(19) Europäisches Patentamt
European Patent Office
Office européen des brevets

(11) EP 2 772 771 B1

(12) FASCICULE DE BREVET EUROPEEN

(45) Date de publication et mention de la délivrance du brevet:
07.02.2018 Bulletin 2018/06

(51) Int Cl.:
G01R 33/36 (2006.01)          H01Q 1/52 (2006.01)
H01Q 7/00 (2006.01)

(21) Numéro de dépôt: 14156587.9

(22) Date de dépôt: 25.02.2014

(54) **Antenne haute fréquence à voies multiples, notamment pour appareil d'imagerie par résonance magnétique nucléaire**

Hochfrequenzantenne mit Mehrwegesystem, insbesondere für Kernspintomographie

Multi-channel high-frequency antenna, in particular for a nuclear magnetic resonance imaging apparatus

(84) Etats contractants désignés:
AL AT BE BG CH CY CZ DE DK EE ES FI FR GB GR HR HU IE IS IT LI LT LU LV MC MK MT NL NO PL PT RO RS SE SI SK SM TR

(30) Priorité: 27.02.2013 FR 1351723

(43) Date de publication de la demande:
03.09.2014 Bulletin 2014/36

(73) Titulaire: COMMISSARIAT À L'ÉNERGIE ATOMIQUE ET AUX ÉNERGIES ALTERNATIVES
75015 Paris (FR)

(72) Inventeurs:
• Luong, Michel
  92330 SCEAUX (FR)
• Ferrand, Guillaume
  75014 PARIS (FR)

(74) Mandataire: Lebkiri, Alexandre
Cabinet Camus Lebkiri
25, Rue de Maubeuge
75009 Paris (FR)

(56) Documents cités:
EP-A1- 2 447 732          WO-A1-2009/081359
US-A1- 2004 066 195       US-A1- 2008 231 278

**Description**

**DOMAINE TECHNIQUE**

La présente invention concerne une antenne haute fréquente fonctionnant en champ proche et présentant des voies multiples en réception et/ou en transmission, utilisée en particulier dans les appareils de Résonance Magnétique Nucléaire (RMN), ainsi que leurs applications : Imagerie par Résonance Magnétique (IRM) pour l'homme ou l'animal, Spectroscopie par Résonance Magnétique (SRM), ou encore imagerie du tenseur de diffusion.

Le domaine de l'invention est celui des antennes à voies multiples fonctionnant en champ proche, utilisées notamment dans le domaine de la Résonance Magnétique Nucléaire (RMN), incluant les applications ci-dessus.

L'invention s'applique particulièrement à des antennes haute fréquence à voies multiples en réception et/ou en transmission utilisées pour l'examen d'un corps humain entier ou uniquement d'une partie du corps, comme par exemple une tête, dans des appareils RMN et plus particulièrement dans les appareils d'Imagerie par Résonance Magnétique (IRM) à très haut champ magnétique, c'est-à-dire au-delà de 7 teslas. Ces appareils ont pour fonction d'exciter les spins magnétiques des atomes d'hydrogène de l'échantillon placé à l'intérieur de l'antenne, et de recueillir le signal de radiofréquence qu'ils émettent lors de la relaxation exposée ci-après.

**ETAT DE LA TECHNIQUE**

D'une façon connue, les antennes des appareils d'IRM sont formées par des éléments rayonnants en cuivre, de formes variables, jouant soit le rôle de bobinages émetteurs, en résonance avec le circuit qui l'alimente, soit le rôle de récepteurs de signaux de relaxation, soit ces deux fonctions alternativement. Elles entourent le patient ou seulement la partie du corps à analyser.

Placées dans le champ magnétique longitudinal permanent $B_0$, d'un dispositif de RMN, elles reçoivent une excitation électrique leur permettant de produire le champ magnétique $B_1$ orthogonal à $B_0$, à la fréquence de résonance de précession ou de relaxation (également appelée fréquence de Larmor) des noyaux des atomes étudiés qui se trouvent dans le champ magnétique $B_0$ et/ou captent le signal de radiofréquence (RF) à la même fréquence de résonance des noyaux qui ont été momentanément soumis au champ magnétique $B_1$.

On rappelle que sous l'effet du champ magnétique statique $B_0$, les moments magnétiques de spin des noyaux d'atomes d'hydrogène vont progressivement s'aligner dans une direction initialement parallèle au champ magnétique $B_0$ et donner lieu à une aimantation globale dans la direction du champ $B_0$, dite direction longitudinale z.

Lorsqu'on applique une excitation sous forme d'une impulsion, c'est-à-dire un champ radiofréquence oscillant à la fréquence de Larmor ayant une composante magnétique notée $B_1$, perpendiculaire à $B_0$, les moments magnétiques de spin vont alors résonner et s'écarter progressivement de cet axe longitudinal z pour aller se placer à un angle de bascule noté FA par rapport à cet axe de départ en décrivant un mouvement, appelé mouvement de précession. Le champ radiofréquence $B_1$ permet donc de faire « basculer » les moments magnétiques de spin sur un angle FA par rapport à la direction du champ $B_0$.

Lorsque l'excitation est interrompue, les moments magnétiques de spin qui se sont écartés de leur axe initial reviennent vers leur position d'équilibre, c'est-à-dire l'axe z, sans cesser de tourner. Ce retour à l'équilibre est appelé relaxation. Il est alors possible de mesurer ce mouvement de rotation des spins sous la forme d'un champ radiofréquence très faible capté par l'antenne, le champ radiofréquence capté ayant la même fréquence que le champ radiofréquence excitateur, c'est-à-dire la fréquence de résonance de Larmor.

Les antennes selon l'invention sont destinées à rayonner le champ magnétique impulsionnel B1, ou à recevoir les signaux générés par la relaxation des noyaux, et préférentiellement à effectuer ces deux fonctions à des moments successifs.

De façon particulière, les antennes utilisées pour l'examen d'une partie du corps et en particulier de la tête, sont des antennes fonctionnant en champ magnétique proche, c'est-à-dire près des éléments physiques rayonnants.

Les antennes de type réseau ont été développées pour fonctionner à des fréquences supérieures à 128 MHz. Elles sont formées par une répartition d'une pluralité de résonateurs, généralement entre 8 et 32, servant d'émetteurs et/ou de récepteurs et qui sont répartis autour de l'échantillon à mesurer.

Chaque résonateur comporte une voie propre, ou canal propre, pour l'émission et/ou une voie propre, ou canal propre pour la réception du signal radiofréquence.

En réception, chaque résonateur permet ainsi de produire une image de la région anatomique en regard de laquelle elle se trouve. Les différentes images sont ensuite combinées par des algorithmes pour former l'image finale.

Le fonctionnement des antennes de type réseau est caractérisé par une inhomogénéité des champs magnétiques radiofréquences émis ou perçus par un seul résonateur : $B_1^+$ en émission et $B_1^-$ en réception.

La quantité du champ $B_1^+$ correspond à la polarisation circulaire du champ magnétique tournant dans le même sens que les spins nucléaires utilisés pour l'imagerie. Par opposition, la quantité de champ $B_1^-$ correspond à la polarisation circulaire du champ magnétique qui tourne dans le sens inverse et qui caractérise la sensibilité en réception.

En émission, l'inhomogénéité de $B_1^+$ se traduit par l'apparition sur une image de zones d'ombre ou de contraste artificiel, difficiles à interpréter. Pour y remédier, une antenne réseau formée par une pluralité de résonateurs doit être utilisée, soit pour :

- uniformiser directement $B_1^+$ ;

- uniformiser l'angle de bascule.

Cette compensation de l'inhomogénéité de $B_1^+$ est d'autant plus efficace que le nombre de résonateurs dans une antenne réseau est élevé.

En réception, un plus grand nombre de résonateurs fournira un profil global de réception plus uniforme avec une augmentation du rapport signal sur bruit comme décrit dans le document [1] (Roemer, P. B. et al. (1990), The NMR phased array, Magnetic Resonance Medicine, 16: 192-225). Cette augmentation du rapport signal sur bruit peut être mise à profit pour accroître la résolution de l'image ou pour diminuer le temps d'acquisition en utilisant une méthode d'accélération qui utilise la sensibilité différentielle entre des résonateurs du fait de leur construction ou de leur répartition autour de l'échantillon.

En bref, l'amélioration des capacités et des performances d'une antenne réseau doit passer par une augmentation du nombre de résonateurs. Or, cette approche est d'autant plus efficace que la taille de chaque résonateur reste inchangée. Il en résulte nécessairement une diminution de la distance entre les résonateurs voisins qui conduit à une augmentation du couplage mutuel entre les résonateurs voisins. A rendement d'émission (ou à sensibilité de réception) égal, l'accroissement du couplage mutuel s'observe par l'accroissement du coefficient de transmission du signal radiofréquence entre les terminaux (ou ports radiofréquences) de résonateurs voisins.

Un couplage mutuel important comporte trois principaux inconvénients :

- un réglage (ie. accord en fréquence et adaptation en impédance) difficile pour chaque résonateur car le réglage d'un résonateur est dépendant du réglage des résonateurs voisins ;

- une perte de rendement en émission car une partie de la puissance injectée est dissipée dans la charge des circulateurs ou dans la résistance interne des amplificateurs de puissance qui alimentent les résonateurs voisins ;

- une augmentation du bruit à la réception car chaque résonateur reçoit le bruit propre des résonateurs voisins.

Une première analyse basée sur la théorie des circuits, divulguée dans le document [2] (Lee, R. F. et al. (2002), Coupling and decoupling theory and its application to the MRI phased array. Magnetic Resonance Medicine, 48 : 203-213), permet de proposer une solution au problème de couplage mutuel. Un découpage efficace est réalisable lorsque les caractéristiques d'un résonateur peuvent être modélisées avec précision. Cependant, la difficulté rencontrée dans la mise en oeuvre de cette théorie résulte de l'interaction forte à haute fréquence, des résonateurs avec l'échantillon à imager placé dans l'antenne et qui modifie les paramètres des modèles.

On connait deux familles d'antenne de type réseau :

- les antennes comportant des résonateurs linéaires constitués par des feuillards de cuivre rectilignes intégrés dans un corps isolant selon la technique des micro-rubans (ou « microstrip » en langue anglaise) et généralement appelée à tort « antenne stripline », et
- les antennes comportant des résonateurs boucles, souvent constitués d'un feuillard en cuivre collé sur un corps isolant souvent souple et appliqué directement sur l'échantillon à analyser.

Des exemples de réalisation ont été décrits dans le document [3] (Adriany, G. et al. (2005), Transmit and receive transmission line arrays for 7 Tesla parallel imaging, Magnetic Resonance in Medicine 53: 434-445).

En raison de la configuration géométrique des résonateurs, le couplage mutuel est plus faible entre deux résonateurs linéaires voisins qu'entre deux résonateurs boucles voisins, pour un nombre donné de résonateurs dans un espace donné. Par conséquent, le problème de couplage mutuel est plus important pour les antennes comportant des résonateurs boucles.

Il a été proposé une méthode de découplage des résonateurs boucles dans le document [1] consistant à superposer les résonateurs boucles. Une telle solution peut conduire à une configuration complexe, difficile à mettre en oeuvre en pratique avec les patients.

Une deuxième méthode de découplage connue consiste à ajouter un circuit passif entre deux résonateurs voisins, comme décrit dans le document [4], (*Birl, M. et al. (2005), Surface Coils Decoupling Means for MRI Systems, Patent n °US6927575 B2*).

Une troisième méthode permettant de s'affranchir des problèmes de couplage mutuel consiste à combiner les deux technologies de résonateurs ; résonateur linéaire et résonateur boucle et à utiliser des résonateurs linéaires en émission et des résonateurs boucles en réception, les résonateurs fonctionnant de manière simultanée. Toutefois, une telle configuration ne permet pas d'optimiser le nombre de résonateurs en émission et en réception, il y a donc perte d'efficacité de l'antenne. Lorsque les résonateurs boucles ne sont utilisés qu'en réception, un choix judicieux ou la transformation optimale de l'impédance des préamplificateurs permet également de réaliser un découplage, comme décrit dans le document [5] (*Yoshida Masaru et al. (2001), RF Coil Array with Reduced Intercoil Coupling, European Patent* EP1122550).

Dans le cas de l'utilisation de résonateurs linéaires uniquement en réception, le découplage peut être également réalisé au moyen de capacités comme décrit dans le document [6] (*Vaughan, J.T. et al. (2011), Coil Element Decoupling for MRI*, US Patent US2011/0312499).

Une quatrième méthode de découplage de résonateurs boucles, décrite dans le document US 2008/0231278, propose l'utilisation d'un résonateur boucle comportant une première boucle principale et une deuxième boucle secondaire positionnée perpendiculaire à la boucle principale en en regard d'un deuxième résonateur boucle adjacent.

Toutefois, aucune des solutions décrites n'est satisfaisante pour une application d'Imagerie par Résonance Magnétique (IRM) à très haut champ magnétique. De plus, les solutions proposées sont complexes à réaliser et coûteuses, et nécessitent l'adjonction de composants et de circuits électriques supplémentaires.

**EXPOSE DE L'INVENTION**

Dans ce contexte, la présente invention vise à résoudre les problèmes mentionnés précédemment en proposant une antenne haute fréquence à voies multiples performante et de conception simple permettant de s'affranchir ou au moins de réduire les problèmes de couplage mutuel de deux résonateurs juxtaposés.

A cette fin, l'invention propose une antenne à voies multiples comportant :

- un premier résonateur boucle comportant un élément rayonnant formant une boucle;
- un deuxième résonateur juxtaposé au premier résonateur boucle comportant un élément rayonnant ; ledit élément rayonnant du premier résonateur boucle présentant :

  - une surface principale S1 définie selon un premier plan moyen ;
  - une surface secondaire S2 définie selon un deuxième plan moyen, la surface secondaire délimitant un appendice dudit élément rayonnant positionné en regard du deuxième résonateur, et présentant une inclinaison par rapport au plan moyen de la surface principale S1;

ladite antenne étant caractérisée en ce que ledit deuxième résonateur est un résonateur linéaire présentant un élément rayonnant rectiligne.

On entend par antenne à voies multiples, une antenne présentant une pluralité de résonateurs servant d'émetteurs et/ou de récepteurs et qui sont répartis autour de l'échantillon à mesurer.

Grâce à l'invention, le découplage mutuel est efficace par le fait que les lignes du champ magnétique rayonné par les résonateurs sont globalement orthogonales, et d'autre part par une exploitation des effets de bord générés par l'inclinaison d'une petite portion du résonateur boucle le long d'une ligne parallèle à l'axe du deuxième résonateur juxtaposé au résonateur boucle.

La portion repliée de l'élément rayonnant du résonateur boucle permet donc d'annuler le courant induit dans le résonateur boucle par la présence d'un deuxième résonateur juxtaposé. Par conséquent, la hauteur de l'appendice, sa taille par rapport à la surface S1 ainsi que l'angle d'inclinaison par rapport à la surface S1 sont des paramètres d'ajustement permettant d'annuler le courant induit dans le résonateur boucle.

Avantageusement, l'antenne est une antenne haute fréquence apte à fonctionner à des fréquences supérieures à 128 MHz.

L'antenne selon l'invention peut également présenter une ou plusieurs des caractéristiques ci-dessous, considérées individuellement ou selon toutes les combinaisons techniquement possibles :

- la surface secondaire S2 délimitant ledit appendice présente des dimensions inférieures aux dimensions de la surface principale ;
- le rapport entre la surface secondaire S2 et la surface principale S1 est inférieur à 1/4 ;
- l'élément rayonnant du résonateur boucle présente une zone de pliure délimitant la surface principale S1 et la surface secondaire S2 ;
- la première surface principale S1 et/ou la surface secondaire S2 est une surface plane ;
- la première surface principale S1 et/ou la surface secondaire S2 est une surface courbée ;
- l'angle d'inclinaison $\alpha$ dudit appendice par rapport à la surface principale S1 du premier résonateur boucle est compris entre 45° et 135° ;
- ledit élément rayonnant du premier résonateur boucle et ledit élément rayonnant du deuxième résonateur sont utilisés pour émettre un signal radio fréquence d'excitation et pour recevoir un signal radiofréquence de relaxation ;
- ledit élément rayonnant du premier résonateur boucle est utilisé pour recevoir un signal radiofréquence de relaxation et ledit élément rayonnant du deuxième résonateur est utilisé pour émettre un signal radio fréquence d'excitation et pour recevoir un signal radiofréquence de relaxation ;
- l'antenne comporte un troisième résonateur juxtaposé au premier résonateur boucle de sorte que le deuxième résonateur et le troisième résonateur sont positionnés de part et d'autre dudit premier résonateur boucle, le premier résonateur boucle présentant un deuxième appendice positionné en regard du troisième résonateur, et présentant une inclinaison $\alpha$ par rapport au plan moyen de la surface principale S1 ;

- l'antenne est une antenne haute fréquence pour appareil de résonance magnétique nucléaire.

## BREVES DESCRIPTIONS DES FIGURES

D'autres caractéristiques et avantages de l'invention ressortiront plus clairement de la description qui en est donnée ci-dessous, à titre indicatif et nullement limitatif, en référence aux figures annexées, parmi lesquelles :

- la figure 1 est un schéma de principe illustrant le phénomène de couplage entre un résonateur linéaire et un résonateur boucle voisins ;
- la figure 2a illustre un schéma de principe d'un premier exemple de montage selon l'invention permettant de découpler deux résonateurs juxtaposés ;
- la figure 2b illustre un schéma de principe d'un deuxième exemple de montage selon l'invention permettant de découpler deux résonateurs juxtaposés ;
- la figure 3 illustre un exemple simplifié d'un premier mode de réalisation d'une antenne haute fréquente à voies multiples selon l'invention ;
- la figure 4 illustre un exemple simplifié d'un deuxième mode de réalisation d'une antenne haute fréquente à voies multiples selon l'invention ;
- les figures 5a et 5b sont des histogrammes illustrant la répartition des sensibilités de réception respectivement obtenues avec une antenne selon l'état de la technique et une antenne selon l'invention.

## DESCRIPTION D'AU MOINS UN MODE DE REALISATION

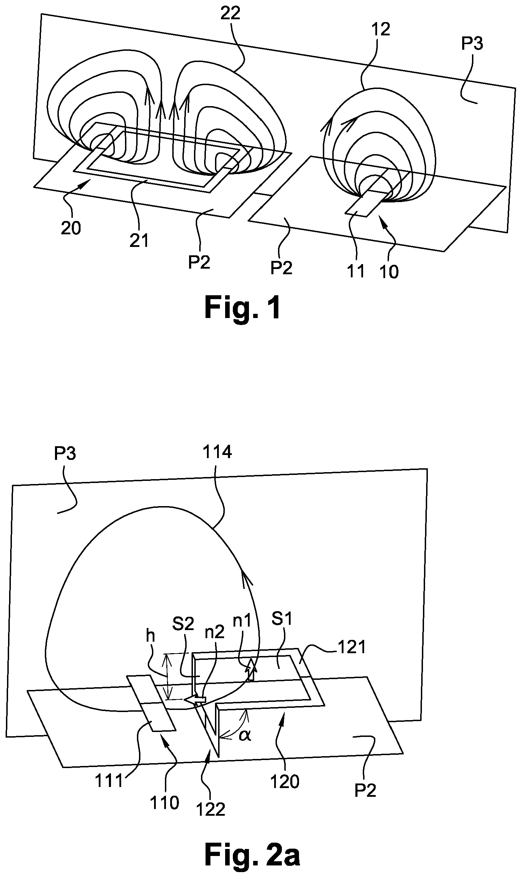

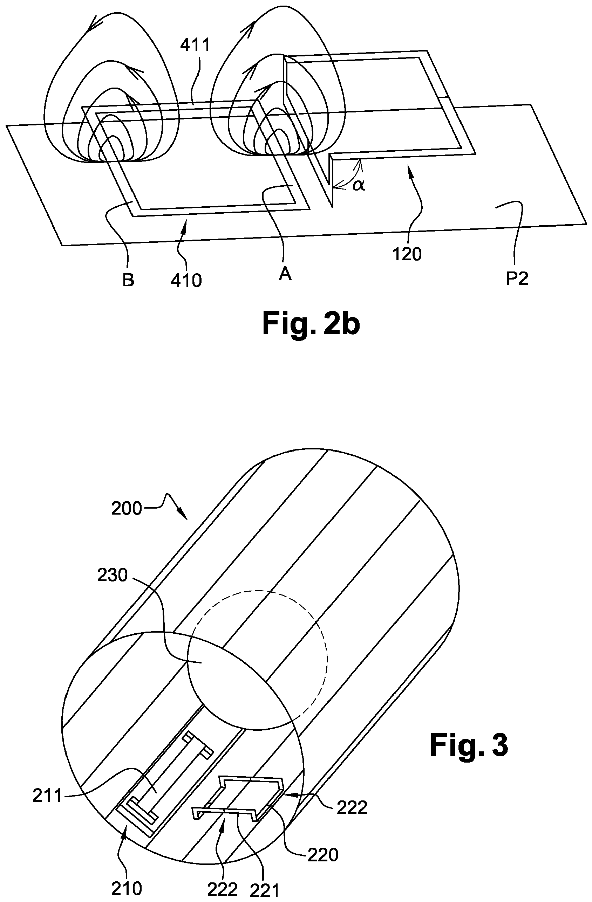

La figure 1 est un schéma de principe illustrant le phénomène de couplage entre un résonateur linéaire 10 et un résonateur boucle 20 voisins.
Classiquement, le résonateur linéaire 10 est formé par un élément rayonnant 11, conducteur électrique, appelé lame, de forme sensiblement rectiligne et connecté en son centre ou à une des deux extrémités au circuit extérieur. A haute fréquence, la lame 11 est généralement placée à une distance donnée (très faible devant la longueur d'onde) d'un plan conducteur P2, dit plan de masse. La lame 11 peut être segmentée et accueillir des capacités en série ou connectée au plan de masse P2 par des capacités en parallèle selon la longueur de la lame 11 et de la fréquence de résonance visée.
Classiquement, le résonateur boucle 20 est formé par un élément rayonnant 21, conducteur électrique, dont la forme épouse le contour d'un cercle ou d'un polygone régulier. Cet élément rayonnant 21, appelé par la suite boucle, peut être découpé en segments reliés entre eux par des capacités afin d'abaisser la fréquence de résonance et de rendre plus uniforme la distribution du courant le long de la boucle. Les bornes d'une des capacités feront office de terminaux radiofréquence (port RF) pour la connexion au circuit extérieur. A haute fréquence, la boucle 21 est généralement placée à une distance donnée (très faible devant la longueur d'onde et la taille de la boucle 21) du plan de masse P2. En fonction de la taille de la boucle 21 et de la fréquence de résonance souhaitée, des capacités peuvent également connecter la boucle 21 au plan de masse P2.
Lorsque le résonateur linéaire 10 est alimenté par un générateur (non représenté), l'élément rayonnant 11, dit lame, situé au-dessus du plan de masse P2, créé un champ magnétique dont les lignes de champ tournent autour de la lame dans un plan P3 perpendiculaire au plan de masse P2, le vecteur de champ étant tangent à ces lignes.
Lorsque le résonateur boucle 20 est alimenté par un générateur (non représenté), l'élément rayonnant 21, dit boucle, crée un champ magnétique dont les lignes de champ 22 sont perpendiculaires à la surface S délimitée par la boucle 21, selon le principe de la loi de Biot-Savart.
En plaçant un résonateur boucle à côté d'un résonateur linéaire, à peu près à la même élévation par rapport au plan de masse commun P2, configuration que l'on retrouve par exemple dans les antennes réseaux utilisées pour l'imagerie médicale, les lignes de champ 12 générées par la lame 11 alimentée électriquement traversent la surface S de la boucle 21 donnant lieu à un flux non nul qui fait apparaître un courant induit dans la boucle 21. Ce courant induit crée un contre-champ qui tend à s'opposer à la variation du flux (Loi de Lenz). Ce phénomène est responsable de la transmission de puissance du résonateur linéaire 10 vers le résonateur boucle 20. Il y a donc couplage mutuel des deux résonateurs juxtaposés.
L'antenne proposée selon l'invention présente une architecture particulière qui permet d'annuler ou au moins de diminuer fortement le courant induit dans la boucle 21 de manière à éviter le phénomène de couplage mutuel entre deux résonateurs sans ajout de composant supplémentaire.
A cet effet, la figure 2a illustre un premier schéma de principe du montage de l'antenne selon l'invention.
Le principe de fonctionnement sera expliqué en considérant le schéma de principe simplifié illustré à la figure 2a qui représente un résonateur boucle présentant une forme en carré positionné à proximité d'un résonateur linéaire.
Le résonateur linéaire 110 est un résonateur classique tel que détaillé précédemment.
Le résonateur boucle 120 est une boucle repliée présentant dans l'espace une première surface plane S1, dite surface principale, et une deuxième surface plane S2, dite surface secondaire et formant un appendice 122 par rapport à la surface principale S1. Dans l'exemple de réalisation simplifié illustré à la figure 2, la surface S2 forme un angle droit par rapport à la surface S1. Bien entendu, l'angle n'inclinaison de 90° n'est pas limitatif et est donné à titre d'exemple. De manière similaire, les surfaces S1 et S2 ne sont pas limitées à des surfaces planes.

Lorsque la lame 111 est alimentée, le champ magnétique $\vec{H}$ rayonné traverse alors les deux surfaces S1 et S2 formées par la boucle 121, créant respectivement un premier flux $\Phi_1$ et un deuxième flux $\Phi_2$ définis par :

$$\Phi_1 = \iint_{S1} \vec{H} \cdot \overrightarrow{n_1}\, dS,$$

$$\Phi_2 = \iint_{S2} \vec{H} \cdot \overrightarrow{n_2}\, dS.$$

La ligne de champ, qui traverse le centre de la surface S1 et le centre de la surface S2, est représentée à titre d'illustration par la référence 114.

De manière générale, les résonateurs opèrent en régime harmonique. La Loi de Lenz permet donc d'évaluer les courants induits $I_1$ et $I_2$ sur l'élément rayonnant 121 bordant respectivement la surface principale S1 et la surface secondaire S2.

$$I_1 = -\frac{1}{R}\left(\frac{d\Phi_1}{dt}\right)$$

$$I_2 = -\frac{1}{R}\left(\frac{d\Phi_2}{dt}\right)$$

Avec :

I : le courant induit en ampère ;
R : la résistance de la boucle en ohm ;
$\Phi$ : le flux magnétique en weber.

En supposant que l'amplitude du champ magnétique $\vec{H}$ rayonné orienté sur la référence 114 décroît sur un intervalle de temps dt, alors la forme particulière de la boucle 121 permet d'obtenir un courant induit $I_1$ positif et un courant induit $I_2$ négatif compte tenu de l'orientation conventionnelle des vecteurs $\overrightarrow{n_1}$ et $\overrightarrow{n_2}$ de la Loi de Lenz. Or, le courant induit total I dans la boucle est la somme des courants $I_1$ et $I_2$. De plus, l'amplitude du champ magnétique H décroit en s'éloignant de la lame, elle est donc plus élevée sur la surface S2 que sur la surface S1.

Par conséquent, l'invention consiste à créer une surface S2 distincte de la surface principale S1, présentant des dimensions inférieures aux dimensions de la surface principale S1, et présentant un angle d'inclinaison $\alpha$ par rapport au plan moyen de la surface S1.

L'orientation et le positionnement de la surface S2 par rapport à la surface S1, ainsi que la taille de la surface S2 par rapport à la surface S1 sont déterminés de manière à ce que les courants induits $I_1$ et $I_2$ générés par la présence du résonateur linéaire 110 à proximité, soient égaux en amplitude de sorte que le courant total induit dans le résonateur boucle 120 s'annule. Ainsi, la forme particulière de la boucle 121 permet de découpler deux résonateurs juxtaposés dans une antenne haute fréquence.

Le principe décrit précédemment reste valable pour des boucles présentant des formes différentes de la forme en carré illustrée.

Pour la réalisation d'une antenne réseau, il convient donc d'alterner un résonateur boucle 120 et un résonateur linéaire 110 de type dipôle, chaque résonateur boucle 120 ayant alors deux résonateurs linéaires 110 voisins. Par conséquent, les boucles 121 doivent comporter deux appendices 122 de part et d'autre de la boucle 121, les appendices 122 étant situés en regard des résonateurs linéaires 110 juxtaposés de part et d'autre.

Pour une lame 111 donnée, l'appendice 122 le plus éloigné de la boucle n'a pas d'effet notable compte-tenu de la décroissance rapide du champ avec la distance.

Le découplage optimal d'une antenne réseau selon l'invention est obtenu par le choix approprié de :

- la surface S2 de l'appendice, qui est directement dépendant de la hauteur h de l'appendice par rapport à la surface principale S1 ;

- l'angle $\alpha$ d'inclinaison de l'appendice par rapport à la surface principale S1 de la boucle.

Avantageusement, le rapport de surface entre la surface secondaire S2 de l'appendice 122 et la surface principale S1 de la boucle 121 est inférieur à 1/4.

A titre d'exemple, la figure 3 illustre un exemple de réalisation d'une antenne haute fréquence à voies multiples 200 selon l'invention pour l'examen d'une tête humaine dans un appareil RMN. La tête est simulée par un fantôme de test 230, sphérique de 78 mm de rayon, rempli d'un gel en agar dont les caractéristiques électriques sont proches de celles du tissu organique.

L'antenne 200 hybride comporte de manière alternée un résonateur boucle 220, présentant une boucle 221 avec deux appendices 222, et un résonateur linéaire 210 de type dipôle (une seule unité de chaque résonateur étant illustrée à la figure 3).

La lame 211 du résonateur linéaire 210 est formée par un conducteur électrique présentant une longueur de 140 mm, une largeur de 15 mm et une épaisseur de 2 mm.

La boucle 221 est formée par un conducteur électrique formant une surface totale S délimitée par un carré de 66x66 mm, le conducteur électrique présentant une section rectangulaire de 2 mm d'épaisseur et 4 mm de large. Pour une utilisation dans un scanner IRM à 7 teslas, le résonateur boucle 220 comporte quatre capacités de 5,8 picofarads (pF) qui sont réparties en série sur la boucle et placées au milieu de chacun des côtés de la boucle de manière à régler la fréquence de résonance à 298 MHz. Pour cette configuration, la hauteur de l'appendice 222 qui annule le courant total induit dans la boucle 221 de dimension 66x66 mm est compris entre 12 et 13 mm.

En utilisant une telle configuration, les coefficients de transmission entre la boucle 221 et la lame 211, qui caractérisent le couplage mutuel, et compris entre -30 dB et -27 dB. Pour une hauteur d'appendice de 12 mm, le champ $B_1^+$ moyen dans le fantôme de test 230, qui indique l'efficacité à l'émission d'un résonateur, est d'environ 0,25 microtesla ($\mu$T) pour une puissance incidente de 1 W, à la fois pour la boucle 221 et pour la lame 211.

A titre de comparaison, si un résonateur linéaire était utilisé à la place du résonateur boucle décrit précédemment, ou si un résonateur boucle selon l'état de la technique était utilisé sans les appendices, le couplage mutuel entre les deux résonateurs serait nettement supérieur à -6 dB, -6 dB étant déjà une valeur très défavorable en terme de réglage et de performance de l'antenne.

En ciblant un couplage mutuel d'une valeur inférieure à -20 dB, la résolution avec laquelle le paramètre h (hauteur de l'appendice) doit être défini est de l'ordre du millimètre (mm). En pratique, il ne sera pas possible de modifier physiquement l'appendice pour ajuster la hauteur h une fois celui-ci formé. La modification de l'angle $\alpha$ d'inclinaison de l'appendice avec la surface principale S1 de la boucle permet de manière avantageuse de modifier et d'ajuster le couplage mutuel de manière à le minimiser. Cette opération peut être réalisée de diverses façons : par exemple par le choix d'une section de conducteur compatible avec un cintrage ; par la mise en place de charnières avec des éléments de blocage entre les appendices et la surface principale S1.

Selon une variante de réalisation, les conducteurs formant les éléments rayonnants des résonateurs boucles peuvent être soutenus et rigidifiés par des pièces de rigidification réalisées en matériaux diélectriques à faibles pertes.

L'angle d'inclinaison $\alpha$ des appendices par rapport à la surface principale S1 est avantageusement choisi entre 45° et 135°. Un tel intervalle d'inclinaison représente une variation relative de la hauteur h de $\pm$ 30%. Ainsi, la plage de variation de l'inclinaison des appendices permet une minimisation aisée du couplage mutuel entre deux résonateurs. Toutefois, cette analyse suppose que le champ magnétique varie peu dans le voisinage de l'appendice. Cette condition est satisfaite lorsque la hauteur h est de l'ordre de 1% de la longueur d'onde. Dans le cas où le résonateur boucle présente deux appendices, ces derniers peuvent présenter des inclinaisons différentes en particulier à cause des réglages finaux nécessaires pour atteindre le couplage mutuel minimal.

Avantageusement, les résonateurs linéaires et les résonateurs boucles décrits dans la présente description sont utilisés à la fois en émission et en réception de manière à optimiser le fonctionnement de l'antenne.

Toutefois, dans certaines applications, il peut être suffisant d'utiliser uniquement les résonateurs linéaires en émission et l'ensemble des résonateurs (linéaires et boucles) en réception.

Dans l'exemple de réalisation de l'antenne réseau selon l'invention, les résonateurs linéaires peuvent être positionnés en retrait par rapport aux résonateurs boucles. A titre d'exemple, la lame est avantageusement positionnée à mi-hauteur de l'appendice. Un décalage de positionnement entre les résonateurs linéaires et les résonateurs boucles permet par exemple de respecter les exigences de débit d'absorption spécifique (DAS), lorsque seuls les résonateurs linéaires sont utilisés en émission.

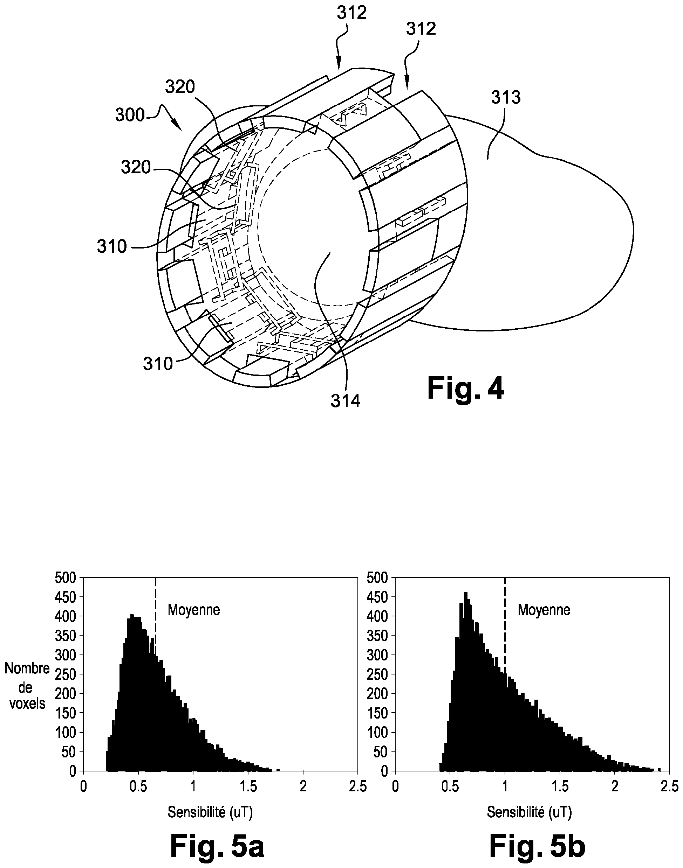

Le second exemple de réalisation illustré à la figure 4 est une antenne réseau 300 présentant douze résonateurs linéaires 310, réparties en deux groupes de six résonateurs 310 positionnés de manière décalée dans le sens longitudinal de l'antenne 300. Avec une technologie selon l'état de la technique, l'augmentation du nombre de résonateurs augmenterait de manière inacceptable le couplage mutuel. Grâce à l'invention, il est possible d'augmenter le nombre de résonateurs en ajoutant dix résonateurs boucles 320 selon l'invention, et potentiellement douze en absence de fenêtres 312 dédiés à la stimulation visuelle utilisées en IRM fonctionnelle.

Pour évaluer, au moyen d'une simulation numérique, la sensibilité en réception d'une antenne réseau en IRM, il est commode d'utiliser le principe de réciprocité et de considérer la distribution de $B_1^-$ lorsqu'un résonateur est alimenté par une puissance incidente de 1 W. Dans le cas d'une antenne réseau comportant N résonateurs, la sensibilité associée à une reconstruction des images par la méthode dite de la somme des carrés est définie par la relation suivante :

$$S = \sum_i^N |B_{1i}^-|^2$$

Le gain en sensibilité en réception obtenu par l'ajout de 10 boucles découplées selon l'invention peut donc être aisément quantifié en évaluant S en chaque voxel de l'échantillon à partir des cartes de champ $B_{1i}^-$ des lames seules ou de la combinaison des lames et des boucles.

Les résultats présentés ci-après correspondent à des cartes obtenues par une simulation numérique avec le code ANSYS HFSS et un fantôme anatomique à deux couches : une enveloppe musculaire 313 et un cerveau 314 de forme ellipsoïdale. La permittivité électrique relative et la conductivité électrique sont respectivement de 59,5 et 0,78 S/m pour la première couche et de 45,3 et 0,87 S/m pour la seconde couche.

Les simulations effectuées montrent un gain moyen dans l'ellipsoïde de 49%, entre la sensibilité en réception des lames seules (état de la technique) et la sensibilité des lames combinées aux boucles selon l'invention. Ce gain n'est pas homogène dans le cerveau en forme d'ellipsoïde sur les trois plans caractéristiques. Le gain le plus important est obtenu dans les zones où la sensibilité en réception des lames seules était la plus faible, ce qui correspond à la partie haute du crâne. Dans cette zone, le gain atteint localement 97%.

La répartition des sensibilités de réception dans les voxels est présentée par les histogrammes des figures 5a et 5b. L'histogramme de la figure 5a correspond à la répartition des sensibilités de réception dans les voxels pour une antenne réseau selon l'état de la technique utilisant uniquement des résonateurs linéaires. L'histogramme de la figure 5b correspond à la répartition des sensibilités de réception dans les voxels pour une antenne réseau hybride selon l'invention illustré à la figure 4. Ainsi, les histogrammes montrent que la sensibilité moyenne est de 0,99 $\mu$T pour le réseau hybride (i. e. lame et boucle) selon l'invention contre 0,67 $\mu$T pour un réseau à lames seules. De plus les zones, où la sensibilité en réception est inférieure à 0,5, ne représentent pas plus que 2% des voxels pour le réseau hybride alors qu'elles représentent 33% pour le réseau à lames seules. L'invention a été particulièrement décrite pour une utilisation en imagerie par résonance magnétique nucléaire ; toutefois, l'invention est également applicable à d'autres domaines d'application utilisant une antenne haute fréquence à voies multiples fonctionnant en champ proche.

L'invention a été particulièrement décrite avec un résonateur boucle avec un élément rayonnant présentant une première surface principale plane et deux appendices plans de part et d'autre de la surface principale. Toutefois, l'invention est également applicable avec une boucle formant une première surface principale courbée (i.e. présentant au moins un rayon de courbure) définie par un plan moyen et/ou deux appendices courbés (i.e. présentant au moins un rayon de courbure) définie également par un plan moyen.

La figure 2b illustre un deuxième schéma de principe de montage de l'antenne selon l'invention qui est une variante du premier principe illustré à la figure 2a.

Dans cette variante de réalisation, le résonateur linéaire 110 est remplacé par un résonateur boucle 410 formé par un élément rayonnant 411, conducteur électrique, dont la forme épouse le contour d'un cercle ou d'un polygone régulier. Le résonateur boucle 410 est un résonateur classique tel que connu par l'homme du métier et tel décrit précédemment à la figure 1 en référence 20.

Dans cette variante de réalisation, les dimensions du résonateur boucle 410 sont déterminées de sorte que le champ magnétique créé par le bord B, c'est-à-dire le bord le plus éloigné du résonateur boucle plié 120, et vu par ce résonateur boucle plié 120 soit négligeable devant le champ magnétique créé par le bord A, c'est-à-dire le bord le plus proche du résonateur boucle plié 120, et vu par ce résonateur boucle plié 120. A titre d'exemple, on peut considérer que le champ magnétique créé par le bord B et perçu par le résonateur boucle plié 120 est négligeable lorsque la distance entre les deux bords A et B est au moins égale à cinq fois la distance entre les deux bords du résonateur boucle plié 120.

L'invention a été particulièrement décrite avec une antenne réseau comportant de manière alternée un résonateur boucle avec deux appendices et un résonateur linéaire de type dipôle. Toutefois, dans certaines applications, il est également envisagé de réaliser une antenne réseau comportant de manière alternée un résonateur boucle avec deux appendices tel que décrit dans la présente demande et un résonateur boucle selon l'état de la technique (ie. sans appendice) avec une largeur au moins égale à cinq fois la largeur du résonateur boucle plié.

## Revendications

**1.** Antenne (200, 300) à voies multiples comportant :

    - un premier résonateur boucle (120, 220, 320) comportant un élément rayonnant (121, 221) formant une boucle ;
    - un deuxième résonateur (110, 210, 310) juxtaposé au premier résonateur boucle (120, 220, 320) comportant un élément rayonnant (111, 211) ; ledit élément rayonnant (121, 221) du premier résonateur boucle (120, 220, 320) présentant :

        - une surface principale S1 définie selon un premier plan moyen ;
        - une surface secondaire S2 définie selon un deuxième plan moyen, la surface secondaire délimitant un appendice (122) dudit élément rayonnant (121, 221) positionné en regard du deuxième résonateur (110, 210, 310), et présentant une inclinaison ($\alpha$) par rapport au plan moyen de la surface principale S1;

    ladite antenne (200, 300) étant **caractérisée en ce que** ledit deuxième résonateur (110, 210, 310) est un résonateur linéaire présentant un élément rayonnant (111, 211) rectiligne.

**2.** Antenne (200, 300) à voies multiples selon la revendication précédente **caractérisée en ce que** la surface secondaire S2 délimitant ledit appendice (122) présente des dimensions inférieures aux dimensions de la surface principale S1.

3. Antenne (200, 300) à voies multiples selon l'une des revendications précédentes **caractérisée en ce que** le rapport entre la surface secondaire S2 et la surface principale S1 est inférieur à 1/4.

4. Antenne (200, 300) à voies multiples selon l'une des revendications précédentes **caractérisée en ce que** l'élément rayonnant (121, 221) du résonateur boucle (120, 220, 320) présente une zone de pliure délimitant la surface principale S1 et la surface secondaire S2.

5. Antenne (200, 300) à voies multiples selon l'une des revendications précédentes **caractérisée en ce que** la première surface principale S1 et/ou la surface secondaire S2 est une surface plane .

6. Antenne (200, 300) à voies multiples selon l'une des revendications précédentes **caractérisée en ce que** la première surface principale S1 et/ou la surface secondaire S2 est une surface courbée.

7. Antenne (200, 300) à voies multiples selon l'une des revendications précédentes **caractérisée en ce que** l'angle d'inclinaison α dudit appendice (122) par rapport à la surface principale (S1) du premier résonateur boucle (120, 220, 320) est compris entre 45° et 135°.

8. Antenne (200, 300) à voies multiples selon l'une des revendications précédentes **caractérisée en ce que** ledit élément rayonnant (121, 221) du premier résonateur boucle (120, 220, 320) et ledit élément rayonnant (111, 211) du deuxième résonateur (110, 210, 310) sont utilisés pour émettre un signal radio fréquence d'excitation et pour recevoir un signal radiofréquence de relaxation.

9. Antenne (200, 300) à voies multiples selon l'une des revendications 1 à 7 **caractérisée en ce que** ledit élément rayonnant (121, 221) du premier résonateur boucle (120, 220, 320) est utilisé pour recevoir un signal radiofréquence de relaxation et ledit élément rayonnant (111, 211) du deuxième résonateur (110, 210, 310) est utilisé pour émettre un signal radio fréquence d'excitation et pour recevoir un signal radiofréquence de relaxation.

10. Antenne (200, 300) à voies multiples selon l'une des revendications précédentes **caractérisée en ce qu'**elle comporte un troisième résonateur (110, 210, 310) juxtaposé au premier résonateur boucle (120, 220, 320) de sorte que le deuxième résonateur (110, 210, 310) et le troisième résonateur (110, 210, 310) sont positionnés de part et d'autre dudit premier résonateur boucle (120, 220, 320), le premier résonateur boucle (120, 220, 320) présentant un deuxième appendice (122) positionné en regard du troisième résonateur (110, 210, 310), et présentant une inclinaison (α) par rapport au plan moyen de la surface principale S1.

11. Antenne (200, 300) à voies multiples selon l'une des revendications précédentes **caractérisée en ce que** l'antenne est une antenne haute fréquence pour appareil de résonance magnétique nucléaire.

**Patentansprüche**

1. Mehrspurige Antenne (200, 300), umfassend:

   - einen ersten Schleifenresonator (120, 220, 320), umfassend ein strahlendes Element (121, 221), das eine Schleife formt;
   - einen zweiten Resonator (110, 210, 310), der neben dem ersten Schleifenresonator (120, 220, 320) angeordnet ist, der ein strahlendes Element (111, 211) umfasst;

   wobei das genannte strahlende Element (121, 221) des ersten Schleifenresonators (120, 220, 320) aufweist:

   - eine Hauptoberfläche S1, die gemäß einer ersten mittleren Ebene definiert ist;
   - eine sekundäre Oberfläche S2, die gemäß einer zweiten mittleren Ebene definiert ist, wobei die sekundäre Oberfläche einen Anhang (122) des genannten strahlenden Elements (121, 221) begrenzt, das gegenüber dem zweiten Resonator (110, 210, 310) positioniert ist und eine Neigung (α) im Verhältnis zur mittleren Ebene der Hauptoberfläche S1 aufweist;

   wobei die genannte Antenne (200, 300) **dadurch gekennzeichnet ist, dass** der genannte zweite Resonator (110, 210, 310) ein linearer Resonator ist, der ein geradliniges strahlendes Element (111, 211) aufweist.

2. Mehrspurige Antenne (200, 300) gemäß dem voranstehenden Anspruch, **dadurch gekennzeichnet, dass** die sekundäre Oberfläche S2, die den genannten Anhang (122) begrenzt, kleinere Abmessungen als die Abmessungen der Hauptoberfläche S1 aufweist.

3. Mehrspurige Antenne (200, 300) gemäß einem der voranstehenden Ansprüche, **dadurch gekennzeichnet, dass** das Verhältnis zwischen der sekundären Oberfläche S2 und der Hauptoberfläche S1 kleiner ist als 1/4.

**4.** Mehrspurige Antenne (200, 300) gemäß einem der voranstehenden Ansprüche, **dadurch gekennzeichnet, dass** das strahlende Element (121, 221) des Schleifenresonators (120, 220, 320) einen Faltbereich aufweist, der die Hauptoberfläche S1 und die sekundäre Oberfläche S2 begrenzt.

**5.** Mehrspurige Antenne (200, 300) gemäß einem der voranstehenden Ansprüche, **dadurch gekennzeichnet, dass** die erste Hauptoberfläche S1 und / oder die sekundäre Oberfläche S2 eine ebene Oberfläche ist / sind.

**6.** Mehrspurige Antenne (200, 300) gemäß einem der voranstehenden Ansprüche, **dadurch gekennzeichnet, dass** die erste Hauptoberfläche S1 und / oder die sekundäre Oberfläche S2 eine gekrümmte Oberfläche ist.

**7.** Mehrspurige Antenne (200, 300) gemäß einem der voranstehenden Ansprüche, **dadurch gekennzeichnet, dass** der Neigungswinkel α des genannten Anhangs (122) im Verhältnis zur Hauptoberfläche (S1) des ersten Schleifenresonators (120, 220, 320) zwischen 45° und 135° inbegriffen ist.

**8.** Mehrspurige Antenne (200, 300) gemäß einem der voranstehenden Ansprüche, **dadurch gekennzeichnet, dass** das genannte strahlende Element (121, 221) des ersten Schleifenresonators (120, 220, 320) und das genannte strahlende Element (111, 211) des zweiten Resonators (110, 210, 310) verwendet werden, um ein Erreger-Funkfrequenzsignal auszugeben und um ein Entspannungs-Funkfrequenzsignal zu empfangen.

**9.** Mehrspurige Antenne (200, 300) gemäß einem der Ansprüche 1 bis 7, **dadurch gekennzeichnet, dass** das genannte strahlende Element (121, 221) des ersten Schleifenresonators (120, 220, 320) verwendet wird, um ein Entspannungs-Funkfrequenzsignal zu empfangen und das genannte strahlende Element (111, 211) des zweiten Resonators (110, 210, 310) verwendet wird, um ein Erreger-Funkfrequenzsignal auszugeben und um ein Entspannungs-Funkfrequenzsignal zu empfangen.

**10.** Mehrspurige Antenne (200, 300) gemäß einem der voranstehenden Ansprüche, **dadurch gekennzeichnet, dass** sie einen dritten Resonator (110, 210, 310) umfasst, der neben dem ersten Schleifenresonator (120, 220, 320) derart angeordnet ist, dass der zweite Resonator (110, 210, 310) und der dritte Resonator (110, 210, 310) auf jeder Seite des genannten ersten Schleifenresonators (120, 210, 320) positioniert sind, wobei der erste Schleifenresonator (120, 220, 320) einen zweiten Anhang (122) aufweist, der gegenüber dem dritten Resonator (110, 210, 310) positioniert ist und eine Neigung (α) im Verhältnis zur mittleren Ebene der Hauptoberfläche S1 aufweist.

**11.** Mehrspurige Antenne (200, 300) gemäß einem der voranstehenden Ansprüche, **dadurch gekennzeichnet, dass** die Antenne eine Hochfrequenzantenne für ein nukleares Magnetresonanzgerät ist.

## Claims

**1.** A multi-channel antenna (200, 300) including:

- a first loop resonator (120, 220, 320) including a radiating element (121, 221) forming a loop;
- a second resonator (110, 210, 310) juxtaposed with the first loop resonator (120, 220, 320) including a radiating element (111, 211);

said radiating element (121, 221) of the first loop resonator (120, 220, 320) having:

- a primary area S1 defined along a first neutral plane;
- a secondary area S2 defined along a second neutral plane, the secondary area delimiting an appendage (122) of said radiating element (121, 221) positioned facing the second resonator (110, 210, 310), and having a tilt (α) with respect to the neutral plane of the primary area S1;

said antenna (200, 300) being **characterized in that** said second resonator (110, 210, 310) is a linear resonator having a rectilinear radiating element (111, 211).

**2.** The multi-channel antenna (200, 300) according to the previous claim, **characterized in that** the secondary area S2 delimiting said appendage (122) has dimensions smaller than the dimensions of the primary area S1.

**3.** The multi-channel antenna (200, 300) according to one of the previous claims, **characterized in that** the ratio of the secondary area S2 to the primary area S1 is smaller than 1/4.

**4.** The multi-channel antenna (200, 300) according to one of the previous claims, **characterized in that** the radiating element (121, 221) of the loop resonator (120, 220, 320) has a folding zone delimiting the primary area S1 and the secondary area S2.

**5.** The multi-channel antenna (200, 300) according to one of the previous claims, **characterized in that** the first primary area S1 and/or the secondary area S2 is a planar area.

**6.** The multi-channel antenna (200, 300) according to one of the previous claims, **characterized in that** the first primary area S1 and/or the secondary area S2 is a curved area.

**7.** The multi-channel antenna (200, 300) according to one of the previous claims, **characterized in that** the angle of tilt $\alpha$ of said appendage (122) with respect to the primary area (S1) of the first loop resonator (120, 220, 320) is between 45° and 135°.

**8.** The multi-channel antenna (200, 300) according to one of the previous claims, **characterized in that** said radiating element (121, 221) of the first loop resonator (120, 220, 320) and said radiating element (111, 211) of the second resonator (110, 210, 310) are used to transmit an excitation radiofrequency signal and to receive a relaxation radiofrequency signal.

**9.** The multi-channel antenna (200, 300) according to one of claims 1 to 7, **characterized in that** said radiating element (121, 221) of the first loop resonator (120, 220, 320) is used to receive a relaxation radiofrequency signal and said radiating element (111, 211) of the second resonator (110, 210, 310) is used to transmit an excitation radiofrequency signal and to receive a relaxation radiofrequency signal.

**10.** The multi-channel antenna (200, 300) according to one of previous claims, **characterized in that** it includes a third resonator (110, 210, 310) juxtaposed with the first loop resonator (120, 220, 320) so that the second resonator (110, 210, 310) and the third resonator (110, 210, 310) are positioned on either side of said first loop resonator (120, 220, 320), the first loop resonator (120, 220, 320) having a second appendage (122) positioned facing the third resonator (110, 210, 310), and having a tilt ($\alpha$) with respect to the neutral plane of the primary area S1.

**11.** The multi-channel antenna (200, 300) according to one of the previous claims, **characterized in that** the antenna is a high frequency antenna for a nuclear magnetic resonance apparatus.

**Fig. 1**

**Fig. 2a**

**Fig. 2b**

**Fig. 3**

**Fig. 4**

**Fig. 5a**

**Fig. 5b**

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 6927575 B2
- EP 1122550 A
- US 20110312499 A
- US 20080231278 A

**Littérature non-brevet citée dans la description**

- **ROEMER, P. B. et al.** *The NMR phased array, Magnetic Resonance Medicine,* 1990, vol. 16, 192-225
- **LEE, R. F. et al.** Coupling and decoupling theory and its application to the MRI phased array. *Magnetic Resonance Medicine,* 2002, vol. 48, 203-213
- **ADRIANY, G. et al.** Transmit and receive transmission line arrays for 7 Tesla parallel imaging. *Magnetic Resonance in Medicine,* 2005, vol. 53, 434-445